Europäisches Patentamt

European Patent Office

Office européen des brevets

(19)

(11) Numéro de publication: **0 237 413 B1**

(12) **FASCICULE DE BREVET EUROPEEN**

(45) Date de publication de fascicule du brevet:
08.05.91

(51) Int. Cl.⁵: **H01L 21/20, C30B 25/02**

(21) Numéro de dépôt: 87400462.5

(22) Date de dépôt: 03.03.87

(54) **Composant en matériau semiconducteur épitaxié sur un substrat à paramètre de maille différent, et application à divers composants en semiconducteurs.**

(30) Priorité: 07.03.86 FR 8603285

(43) Date de publication de la demande:
16.09.87 Bulletin 87/38

(45) Mention de la délivrance du brevet:
08.05.91 Bulletin 91/19

(84) Etats contractants désignés:
**DE GB NL**

(56) Documents cités:
**DE-A- 2 034 384**
**FR-A- 2 403 567**
**GB-A- 2 030 767**
**US-A- 4 517 047**

**APPLIED PHYSICS LETTERS, vol. 46, no. 1, janvier 1985, pages 46-48, American Institute of Physics, Woodbury, New Jersey, US; M. RAZEGHI et al.: "Two-dimensional electron gases in quantum well and superlattices of Ga0.25 In0.75 As0.50 P0.50/InP heterostructures grown by low pressure metalorganic chemical vapor deposition"**

**JOURNAL OF CRYSTAL GROWTH, vol. 70, no.**

1/2, décembre 1984, pages 145-149, Elsevier Science Publishers B.V., Amsterdam, NL; M. RAZEGHI et al.: "Recent advances in MOCVD growth of InxGa1-xAsyP1-yAlloys"

(73) Titulaire: **THOMSON-CSF**
**51, Esplanade du Général de Gaulle**
**F-92800 Puteaux(FR)**

(72) Inventeur: **Razeghi, Manijeh**
**THOMSON-CSF SCPI 19, avenue de Messine**
**F-75008 Paris(FR)**
Inventeur: **Meunier, Paul-Louis**
**THOMSON-CSF SCPI 19, avenue de Messine**
**F-75008 Paris(FR)**

(74) Mandataire: **Lepercque, Jean et al**
**THOMSON-CSF SCPI**
**F-92045 PARIS LA DEFENSE CEDEX 67(FR)**

## Description

L'invention concerne un composant en matériau semiconducteur épitaxié sur un substrat à pararnètre de maille différent et son application à divers composants en semiconducteurs tels que diode, photorésistance, guide optique intégré, isolateur optique, circulateur optique, détecteur magnétique.

L'invention est notamment applicable à un composant en matériau de type III- V implanté sur un substrat.

La réalisation d'un tel composant est souvent difficile car il faut choisir un matériau semiconducteur dont le paramètre de maille soit adapté au paramètre de maille du substrat. C'est ainsi que le paramètre de maille d'un substrat en Grenat de Gadolinium et Gallium, dont la valeur est 1,2383nm (12,383 Angstroems), est totalement désadapté par rapport aux matériaux semiconducteurs connus. Dans le domaine des diodes émettrices/réceptrices de lumière, le Brevet français FR-A-2 574 566 déposé le 11 décembre 1984 apportait une solution en proposant à titre d'exemple une composition de matériau semiconducteur à base de Gallium, d'Indium, d'Aluminium et d'Antimoine (GaInAlSb) dont le paramètre de maille de 0,619nm (6,19 Angstroems) s'ajuste sensiblement à la moitié du paramètre de maille du grenat en Gadolinium et Galium.

Cependant, l'ajustement des paramètres de maille à un multiple ou un sous-multiple du paramètre de maille du substrat demande un dosage des différents métalorganiques utilisés très précis. De plus, ce dosage implique un matériau de caractéristiques physiques déterminées qui pourrait être déterminantes pour le domaine d'application.

Le document US 4 517 047 décrit un super-réseau d'adaptation dont les couches présentent des compositions qui varient graduellement.

L'invention fournit un composant plus facile à réaliser et évite donc ces inconvénients.

Pour cela elle utilise un procédé connu de croissance épitaxiale d'une succession de couches. Ce procédé utilise une technique récente de croissance épitaxiale appelée épitaxie en phase vapeur d'organométalliques, MOCVD (Metalorganic Chemical Vapor Deposition en terminologie anglo-saxonne). Une telle succession de couches obtenues par ce procédé est appelée super-réseau (superlattice en terminologie anglo-saxonne) et est décrite dans l'article "Croissance et caractérisation de l'hétérojonction et de structures à puits quantiques GaInAs-InP obtenues par MOCVD "de Manijeh RAZEGHI publié dans la Revue Technique THOMSON-CSF - Vol. 16 - N° 1 - mars 1984 pages 5 à 27 ainsi que dans le chapitre 5 "LowPressure Metallo-Organic Chemical Vapor Deposition of $Ga_xIn_{1-x}As_yP_{1-y}$ Alloys" de Manijeh RAZEGHI (paragraphe IV, pages 317 à 345) publié dans l'ouvrage "Semiconductors and Semimetals", vol. 22, part A, par Bell Telephone Laboratories.

Le composant obtenu présente l'avantage de ne pas être perturbé par les éventuels défauts dus à des dislocations à l'interface composant-substrat et se présente sous la forme d'un monocristal.

L'invention concerne donc un composant en matériau semiconducteur épitaxié sur un substrat à paramètre de maille différent, caractérisé en ce qu'il comporte réalisé sur un substrat possédant un paramètre de maille déterminé, une succession alternée d'un premier type de couches dont le nombre est au moins 2, et d'un deuxième type de couches dont le nombre est au moins 2, ainsi qu'un composant réalisé sur ladite succession de couches, une première couche du premier type étant réalisée sur le substrat et le composant étant réalisé sur la dernière couche du deuxième type, le premier type de couches étant réalisé en un premier matériau semiconducteur dont le paramètre de maille est sensiblement adapté à un multiple ou un sous-multiple du paramètre de maille du substrat, le deuxième type de couches étant réalisé en un deuxième matériau semiconducteur dont le paramètre de maille est adapté à un multiple ou un sous-multiple du paramètre de maille du premier matériau du premier type de couches, le composant étant réalisé avec un matériau de même paramètre de maille que celui du deuxième matériau semiconducteur, les gaps d'énergie du premier type de couches et du deuxième type de couches étant différents.

Les différents objets et caractéristiques de l'invention apparaîtront plus clairement à l'aide de la description qui va suivre, faite en se reportant aux figures annexées qui représentent :

- la figure 1, un exemple de réalisation du composant selon l'invention ;
- la figure 2, un schéma explicatif du fonctionnement du composant selon l'invention ;
- la figure 3, un exemple de réalisation d'une photorésistance selon l'invention ;
- la figure 4, un exemple de réalisation d'un isolateur intégré selon l'invention ;
- la figure 5, un exemple de réalisation d'un détecteur magnétique selon l'invention ;
- la figure 6, une variante de réalisation de l'invention dans laquelle on prévoit plusieurs super-réseaux.

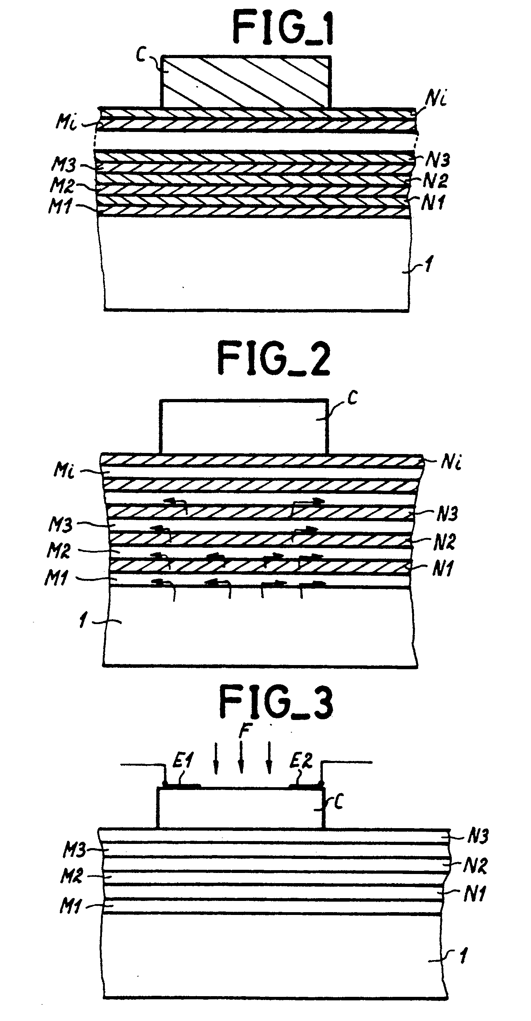

En se reportant à la figure 1, on va donc décrire un exemple de réalisation selon l'invention.

Sur un substrat 1, on fait croître une succession de couches M1 à Mi et N1 à Ni.

Le substrat est un matériau semiconducteur tel que par exemple de l'arséniure de Gallium (GaAs) ou un grenat de Gadolinium et Gallium (GGG). Le substrat peut être également un matériau ferriélectrique et d'une manière générale tout matériau sur lequel on doit faire croître un composant semiconducteur.

Les couches M1, M2, ... Mi sont réalisées avec un matériau semiconducteur ayant un paramètre de maille a2 sensiblement adapté au multiple ou au sous-multiple du paramètre de maille a1 du substrat.

Les couches N1, N2,... Ni sont réalisées avec un matériau semiconducteur ayant un paramètre de maille a3 adapté au paramètre de maille a2 des couches M1, M2,... Mi.

Les couches M1, M2,... Mi ont des gaps d'énergie nettement différents des gaps d'énergie des couches N1, N2, ... Ni. On aura donc des couches M1 à M2 présentant une affinité électronique très différente de celle des couches NI à Ni. On observe alors à l'interface entre chaque couche N et la couche M qui lui est superposée, à une séparation spatiale entre électrons et impuretés créant une couche d'accumulation de haute densité.

Les dissymétries cristallographiques entre le substrat 1 et la couche M 1 et les différences de paramètres de mailles créent des défauts de dislocations dus aux désadaptations des paramètres cristallins entre le substrat et la première couche épitaxiale. Pour supprimer ces défauts, chaque transition entre une couche M et une couche N a pour effet de créer une déviation de l'angle de dislocation. Comme cela est indiqué par des flèches sur la figure 2, à chaque interface entre une couche N et une couche M, il y a donc absorption de défauts.

En prévoyant un nombre de couches suffisantes, on obtient un amortissement des défauts qui ne parvient pas au composant C.

A titre d'exemple, avec des couches de 5 à 15 nanomètres (50 à 150 Angstroems) d'épaisseur et avec au total environ une vingtaine de couches, on obtient une bonne absorption des défauts.

Le composant C est réalisé en matériau semiconducteur dont le paramètre est adapté au paramètre de maille a3 de la couche Ni, voire égal au paramètre de maille a3.

La croissance des différentes couches et du composant C se fait par épitaxie selon un procédé appelé croissance par épitaxie en phase vapeur et décrit notamment dans les documents précédemment cités.

La présente invention s'applique à divers composants tels que diodes, laser, guide d'onde, transistors intégrés, isolateurs optiques, détecteurs optiques, réalisés en matériaux semiconducteurs.

A titre d'exemple d'application de l'invention, la figure 3 représente une photorésistance dont le composant C est réalisé en Arséniure de Gallium et d'Indium (GaInAs) et dont les caracteristiques électriques (impédances) varient sous l'effet d'un rayonnement de longueur d'onde compris entre 1,3 micromètres et 1,5 micromètres. La partie supérieure de la photorésistance comporte deux électrodes de connexions électriques permettant de connecter la photorésistance vers des circuits utilisateurs. De plus, la face supérieure de la photorésistance est éclairée par un rayonnement F de longueur d'onde détectable par la photorésistance.

La photorésistance C est en GaInAs et est réalisée sur une succession de couches M1 à M3 et N1 à N3, lesquelles sont réalisées sur un substrat 1. Le substrat 1 est en Arséniure de Gallium. Les couches M1 à M3 sont en phosphore d'indium. Les couches N1 à N3 sont en Arséniure de Gallium et d'Indium.

La photorésistance C peut être réalisée en un autre matériau sensible à d'autres longueurs d'ondes comme expliqué précédemment, il faudra alors choisir des couches intermédiaires M1 à M3 et N1 à N3 permettant un bon amortissement des défauts.

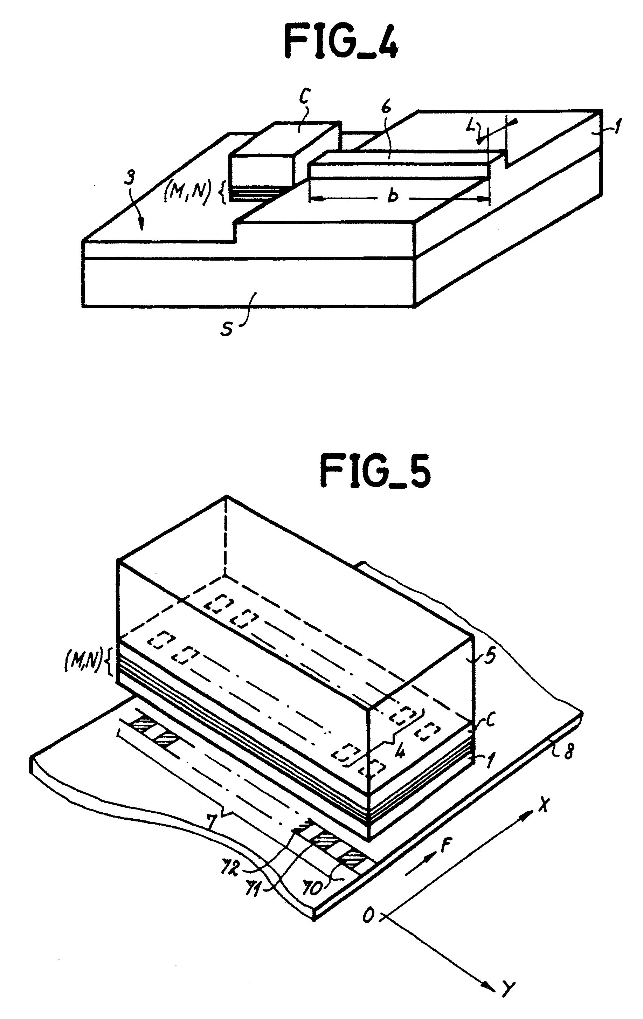

La figure 4 représente un isolateur intégré tel que décrit dans le Brevet français n° FR-A-2 574 566 déposé le 11 décembre 1984. Cet isolateur comporte sur un grenat de Gadolinium et Gallium S, une couche 1 d'un matériau ferrimagnétique tel qu'un grenat d'Yttrium et de fer (YIG). Ce matériau ferrimagnétique possède un paramètre de maille s'adaptant convenablement au grenat de Gadolinium et Gallium S.

Une zone 3 de la couche 1 a été usinée et porte une diode émettrice C. L'autre zone de la couche 1 possède un guide usiné dans la couche de YIG. Les dimensions (L, b) du guide sont telles que la lumière émise par la diode C ne puisse se réfléchir vers la diode et perturber son fonctionnement, d'où la désignation "isolateur intégré".

La diode C est réalisée sur la couche 1 de YIG après réalisation d'une succession de couches ou super-réseau M, N. Les couches M et N seront réalisées comme décrit précédemment à l'aide de matériaux III-V choisis en fonction de leur paramètre de maille et de leur gap d'énergie.

Selon la même technique que le présent isolateur, on peut réaliser un circulateur appliquant l'invention en prévoyant plusieurs diodes émettrices/réceptrices reliées deux à deux par de tels isolateurs réalisés sur le même substrat.

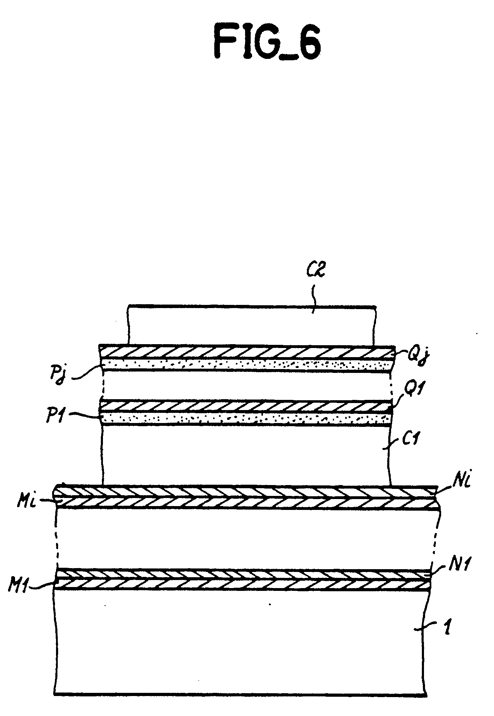

La figure 5 représente un détecteur magnétique de capteur à effet magnéto résistif linéaire. Ce capteur est constitué principalement d'une couche d'un matériau semiconducteur C portant sur une face une couche d'un matériau ferrimagnétique 1 et, sur l'autre face, au moins un couple d'électrodes (4) disposées selon un axe OX.

Ce capteur est disposé de telle façon que sa couche de matériau ferrimagnétique 1 est placé à proximité d'un support magnétique 8 à lire de telle façon qu'une information magnétique 70 à 72 induise un champ magnétique dans la couche de matériau semiconducteur C selon une direction OY perpendiculaire à l'axe OX du couple d'électrodes.

Pour que le fonctionnement d'un tel capteur soit correct, il convient que la couche de matériau semiconducteur C soit adaptée à la couche de matériau ferrimagnétique 1. En prévoyant une succession de couches M, N ou super-réseau, on se prémunit contre les défauts dus à des risques de désadaptation.

L'invention est applicable comme cela est expliqué précédemment à d'autre type de composants sans sortir du cadre de l'invention.

Selon une variante de l'invention, on prévoit une succession de super-réseaux tels que décrits précédemment superposés les uns sur les autres. Par exemple, comme cela est représenté sur la figure 6, sur un substrat 1, on réalise un premier super-réseau M1-Mi, N1-Ni qui permet de réaliser un premier composant C1. Pour réaliser sur le composant C1 un deuxième composant C2 de nature différente du composant C1, on réalise un deuxième super-réseau P1-Pj, Q1-Qj sur le composant C1. La nature des matériaux des couches P1-Pj d'une part, et des couches Q1-Qj d'autre part est choisie en fonction de leurs paramètres de mailles et des gaps d'énergie, comme cela a été décrit précédemment pour les couches M1-Mi, N1-Ni. De cette façon, il est possible de réaliser un composant C2 sur le composant C1. Il est bien évident, qu'il est alors possible de réaliser plusieurs composants tels que C2 sur le composant C1.

Selon ce qui a été décrit pour le premier super-réseau M1-Mi, N1-Ni. Le paramètre de maille des couches M1-Mi est sensiblement adapté au multiple ou sous-multiple du paramètre de maille du composant C1. Le paramètre de maille des couches N1-Ni est, lui, adapté voire égal au paramètre de maille des couches M1-Mi. Le paramètre de maille du composant C2 est égal au paramètre de maille des couches N1-Ni.

De même, sans sortir du cadre de l'invention, on prévoit de réaliser sur un composant tel que C2, un ou plusieurs composants, non représentés, sur la figure, par l'intermédiaire d'un autre super-réseau permettant de réaliser l'adaptation.

L'invention est applicable à des composants utilisables aussi bien dans le domaine de l'optoélectronique, que celui des télécommunications optiques ou celui des hyperfréquences.

**Revendications**

1. Composant en matériau semiconducteur épitaxié sur un substrat à paramètre de maille différent, caractérisé en ce qu'il comporte réalisé sur le substrat possédant un paramètre de maille déterminé (a1), une succession alternée d'un premier type de couches (M1, Mi) dont le nombre (i) est au moins 2 et d'un deuxième type de couches (N1, Ni) dont le nombre (i) est également au moins 2, ainsi qu'un composant (C) réalisé sur ladite succession de couches, une première couche (M1) du premier type étant réalisée sur le substrat et le composant (C) étant réalisé sur la dernière couche (Ni) du deuxième type, le premier type de couches (M1, Mi) étant réalisé en un premier matériau semiconducteur dont le paramètre de maille (a2) est sensiblement adapté à un multiple ou un sous-multiple du paramètre de maille (a1) du substrat, le deuxième type de couches (N1, Ni) étant réalisé en un deuxième matériau semiconducteur dont le paramètre de maille (a3) est adapté à un multiple ou un sousmultiple du paramètre de maille (a2) du premier matériau du premier type de couches, le composant (C) étant réalisé avec un matériau de même paramètre de maille (a3) que celui du deuxième matériau semiconducteur, les gaps d'énergie du premier type de couches et du deuxième type de couches étant différents.

2. Composant selon la revendication 1, caractérisé en ce que le deuxième type de couche (Ni) est réalisé en un deuxième matériau semiconducteur dont le paramètre de maille (a3) est égal au paramètre de maille (a2) du premier matériau du premier type de couches (Mi).

3. Composant selon la revendication 1, caractérisé en ce que le substrat (1) est un grenat de Gadolinium et Gallium, ledit premier matériau est du phosphore d'Indium (InP), ledit deuxième matériau est de l'Arséniure de Gallium et d'Indium (GaInAs).

4. Composant selon la revendication 1, caractérisé en ce que le substrat (1) est en matériau ferrimagnétique.

5. Composant selon la revendication 1, caractérisé en ce que le substrat (1) est de l'Arséniure de Gallium.

6. Composant selon la revendication 3, caractérisé en ce que le matériau ferrimagnétique est un grenat d'Yttrium et de fer.

7. Composant selon la revendication 1, caractérisé en ce que l'épaisseur de chaque couche est d'environ 5 nanomètres (50 Angstroems) à 15 nanomètres (150 Angstroems).

8. Composant selon la revendication 1, caractérisé en ce que le nombre de couches est supérieur à dix couches.

9. Composant selon la revendication 1, caractérisé en ce que le composant (C) est une diode laser.

10. Composant selon la revendication 1, caractérisé en ce que le composant (C) est une photorésistance.

11. Composant selon la revendication 1, caractérisé en ce que le composant (C) est un guide optique intégré.

12. Composant selon la revendication 1, caractérisé en ce que le composant (C) est un isolateur optique intégré.

13. Composant selon la revendication 1, caractérisé en ce que le composant (C) est un circulateur optique.

14. Composant selon la revendication 3, caractérisé en ce que le composant (C) est un détecteur magnétique.

15. Composant selon la revendication 1, caractérisé en ce que le composant (C) est une photorésistance en Arséniure de Gallium et d'Indium réalisée sur un substrat en Arséniure de Gallium, la succession alternée du premier type de couches (M1 à M5) et du deuxième type de couches (N1 à N5) étant, pour le premier type de couches, en phosphore d'indium et pour le deuxième type de couches en Arséniure de Gallium et d'Indium.

16. Composant selon la revendication 1, caractérisé en ce qu'il comporte sur un premier composant (C1) une succession alternée d'un troisième type de couches (P1Pj) et d'un quatrième type de couches (Q1-Qj) ainsi qu'au moins un deuxième composant (C2) réalisé sur cette dite succession de couches, une première couche (P1) du troisième type étant réalisée sur le premier composant (C1) et le composant (C2) étant situé sur une dernière couche (Qj) du quatrième type, le paramètre de maille du matériau du troisième type de couche (P1-Pj) étant sensiblement adapté au multiple ou au sous-multiple du paramètre de maille du matériau du premier composant (C1), le paramètre de maille du matériau du quatrième type de couches (Q1-Qj) étant adapté au multiple ou au sous-multiple du paramètre de maille du matériau du troisième type de couches (P1-Pj), le paramètre de maille du deuxième composant (C2) étant adapté au paramètre de maille du matériau de la quatrième couche (Q1-Qj).

17. Composant selon la revendication 16, caractérisé en ce que plusieurs composants tels que le deuxième composant (C2) peuvent être réalisés sur la succession de couches des troisièmes (P1-Pj) et quatrième (Q1-Qj) types de couches.

18. Composant selon la revendication 16, caractérisé en ce que plusieurs successions de couches peuvent être réalisées sur le deuxième composant (C2) pour réaliser d'autres composants.

## Claims

1. A component made of epitaxy semiconductor material on a substrate with different lattice parameters, characterized in that, realized on the substrate possessing a predetermined lattice parameter (a1), an alternating succession of a first layer type (M1 and Mi), the number (i) thereof being equal to at least two, and of a second layer type (N1 and Ni), the number (i) thereof being also equal to at least two and a component (C) realized on the said succession of layers, a first layer (M1) of the first type being realized on the substrate and the component (C) being realized on the last layer (Ni) of the second type, the first layer type (M1 and Mi) being realized in a first semiconductor material whose lattice parameter (a2) is substantially adapted to a multiple or to a submultiple of the lattice parameter (a1) of the substrate, the second layer type (N1 and Ni) being realized in a second semiconductor material whose lattice parameter (a3) is adapted to a multiple or to a submultiple of the lattice parameter (a2) of the first material of the first layer type, the component (C) being realized with a material with the same lattice parameter (a3) as that of the second semiconductor material, the energy gaps of the first layer type and of the second layer type being different.

2. The component as claimed in claim 1, characterized in that the second type of layer (Ni) is realized in a second semiconductor material, whose lattice parameter (a3) is equal to the lattice parameter (a2) of the first material of the first layer type (Mi).

3. The component as claimed in claim 1, characterized in that the substrate (1) is gadolinium gallium garnet, the said first material is indium phosphide (InP) and the said second material is gallium indium arsenide (GaInAs).

4. The component as claimed in claim 1, characterized in that substrate (1) Is made of a ferrimagnetic material.

5. The component as claimed in claim 1, characterized in that the substrate (1) is gallium arsenide.

6. The component as claimed in claim 3, characterized in that the ferrimagnetic material is an yttrium iron garnet.

7. The component as claimed in claim 1, characterized in that the thickness of each layer is between approximately 5 nanometers (50 angstroms) and 15 nanometers (150 angstroms).

8. The component as claimed in claim 1, characterized in that the number of layers is greater than ten.

9. The component as claimed in claim 1, characterized in that the component (C) is a laser diode.

10. The component as claimed in claim 1, characterized in that the component (C) is a photoresistor.

11. The component as claimed in claim 1, characterized in that the component (C) is an integrated optical guide.

12. The component as claimed in claim 1, characterized in that the component (C) is an integrated optical insulator.

13. The component as claimed in claim 3, characterized in that the component (C) is an optical circulator.

14. The component as claimed in claim 3, characterized in that the component (C) is a magnetic detector.

15. The component as claimed in claim 1, characterized in that the component (C) is a gallium indium arsenide photoresistor realized on a substrate of gallium arsenide, the alternating succession of the first layer type (M1 to M5) and of the second layer type (N1 to N5) being, for the first layer type, made of indium phosphide and for the second layer type of gallium indium arsenide.

16. The component as claimed in claim 1, characterized in that on a first component (C1) It comprises an alternating succession of a third layer type (P1 to Pj) and of a fourth layer type (Q1 to Qj) and also at least one second component (C2) realized on this said succession of layers, a first layer (P1) of the third type being realized on the first component (C1) and the component (C2) being placed on a last layer (Qj) of the fourth type, the lattice parameter of the third type of layer (P1 and Pj) being substantially adapted to the multiple or to the submultiple of the lattice parameter of the material of the first component (C1), the lattice parameter of the material of the fourth layer type (Q1 to Qj) being adapted to the multiple or to the submultiple of the lattice parameter of the material of the third layer type (P1 to Pj), the lattice parameter of the material of the second component (C2) being adapted to the parameter of the material of the fourth layer (Q1 to Qj).

17. The component as claimed in claim 16, characterized in that a plurality of components such as the second component (C2) may be realized on the succession of layers of the third (P1 to Pj) and of the fourth (Q1 to Qj) layer types.

18. The component as claimed in claim 16, characterized in that the plurality of successions of layers may be realized on the second component (C2) in order to realize other components.

## Ansprüche

1. Bauteil aus einem Halbleitermaterial, das epitaktisch auf einem Substrat mit unterschiedlichem Gitterparameter aufgebracht ist, dadurch gekennzeichnet, daß es eine auf dem einen bestimmten Gitterparameter (a1) besitzenden Substrat verwirklichte abwechselnde Folge eines ersten Schichttyps (M1, Mi), dessen Anzahl (i) mindestens 2 ist, und eines zweiten Schichttyps (N1, Ni), dessen Anzahl (i) ebenfalls mindestens 2 ist, und ein auf der Schichtfolge verwirklichtes Bauteil (C) umfaßt, wobei die erste Schicht (M1) vom ersten Typ auf dem Substrat verwirklicht ist und das Bauteil (C) auf der letzten Schicht (Ni) vom zweiten Typ verwirklicht ist, wobei der erste Schichttyp (M1, Mi) auf einem ersten Halbleitermaterial verwirklicht ist, dessen Gitterparameter (a2) im wesentlichen einem Vielfachen oder einem gemeinsamen Teiler des Gitterparameters (a1) des Substrates angepaßt ist, wobei der zweite Schichttyp (N1, Ni) aus einem zweiten Halbleitermaterial verwirklicht ist, dessen Gitterparameter (a3) an ein Vielfaches oder einen gemeinsamen Teiler des Gitterparameters (a2) des ersten Materials des ersten Schichttyps angepaßt ist, wobei das Bauteil (C) aus einem Material mit dem gleichen Gitterparameter (a3) wie derjenige des zweiten Halbleitermaterials verwirklicht ist, wobei die Energieabstände des ersten Schichttyps und des zweiten Schichttyps verschieden sind.

2. Bauteil gemäß Anspruch 1, dadurch gekennzeichnet, daß der zweite Schichttyp (Ni) aus einem zweiten Halbleitermaterial hergestellt ist, dessen Gitterparameter (a3) gleich dem Gitterparameter (a2) des ersten Materials des ersten Schichttyps (Mi) ist.

3. Bauteil gemäß Anspruch 1, dadurch gekennzeichnet, daß das Substrat (1) ein Granat aus Gadolinium und Gallium ist, das erste Material Indium-Phosphor (InP) ist und das zweite Material Gallium-Indium-Arsenid (GaInAs) ist.

4. Bauteil gemäß Anspruch 1, dadurch gekennzeichnet, daß das Substrat (1) ein ferrimagnetisches Material ist.

5. Bauteil gemäß Anspruch 1, dadurch gekennzeichnet, daß das Substrat (1) Gallium-Arsenid ist.

6. Bauteil gemäß Anspruch 4, dadurch gekennzeichnet, daß das ferrimagnetische Material ein Yttrium-Eisen-Granat ist.

7. Bauteil gemäß Anspruch 1, dadurch gekennzeichnet, daß die Dicke einer jeden Schicht ungefähr 5 Nanometer (50 Angstroems) bis 15 Nanometer (150 Angstroems) beträgt.

8. Bauteil gemäß Anspruch 1, dadurch gekennzeichnet, daß die Anzahl der Schichten größer als zehn ist.

9. Bauteil gemäß Anspruch 1, dadurch gekennzeichnet, daß das Bauteil (C) eine Laserdiode ist.

10. Bauteil gemäß Anspruch 1, dadurch gekennzeichnet, daß das Bauteil (C) ein Photowiderstand ist.

11. Bauteil gemäß Anspruch 1, dadurch gekennzeichnet, daß das Bauteil (C) ein integrierter Lichtleiter ist.

12. Bauteil gemäß Anspruch 1, dadurch gekennzeichnet, daß das Bauteil (C) ein integrierter optischer Isolator ist.

13. Bauteil gemäß Anspruch 1, dadurch gekennzeichnet, daß das Bauteil (C) ein optischer Zirkulator ist.

14. Bauteil gemäß Anspruch 3, dadurch gekennzeichnet, daß das Bauteil (C) ein Magnetdetektor ist.

15. Bauteil gemäß Anspruch 1, dadurch gekennzeichnet, daß das Bauteil (C) ein Photowiderstand aus Gallium-Indium-Arsenid ist, der auf einem Substrat aus Gallium-Arsenid verwirklicht ist, wobei die abwechselnde Folge des ersten Schichttyps (M1 bis M5) und des zweiten Schichttyps (N1 bis N5) für den ersten Schichttyp aus Indium-Phosphor und für den zweiten Schichttyp aus Gallium-Indium-Arsenid besteht.

16. Bauteil gemäß Anspruch 1, dadurch gekennzeichnet, daß es auf einem ersten Bauteil (C1) eine abwechselnde Folge eines dritten Schichttyps (P1-Pj) und eines vierten Schichttyps (Q1-Qj) und wenigstens ein zweites Bauteil (C2), das auf dieser Schichtfolge verwirklicht ist, umfaßt, wobei eine erste Schicht (P1) vom dritten Typ auf dem ersten Bauteil (C1) verwirklicht ist und das Bauteil (C2) auf einer letzten Schicht (Qj) vom vierten Typ angeordnet ist, wobei der Gitterparameter des Materials des dritten Schichttyps (P1-Pj) im wesentlichen an das Vielfache oder den gemeinsamen Teiler des Gitterparameters des Materials des ersten Bauteils (C1) angepaßt ist, wobei der Gitterparameter des Materials des vierten Schichttyps (Q1-Qj) an das Vielfache oder den gemeinsamen Teiler des Gitterparameters des Materials des dritten Schichttyps (P1-Pj) angepaßt ist und wobei der Gitterparameter des zweiten Bauteils (C2) an den Gitterparameter des Materials des vierten Schichttyps (Q1-Qj) angepaßt ist.

17. Bauteil gemäß Anspruch 16, dadurch gekennzeichnet, daß eine Mehrzahl von Bauteilen wie etwa das zweite Bauteil (C2) auf der Folge von Schichten des dritten (P1-Pj) und des vierten (Q1-Qj) Schichttyps verwirklicht werden können.

18. Bauteil gemäß Anspruch 16, dadurch gekennzeichnet, daß eine Mehrzahl von Folgen von Schichten auf dem zweiten Bauteil (C2) verwirklicht werden können, um andere Bauteile zu verwirklichen.

# FIG_1

# FIG_2

# FIG_3

# FIG_4

# FIG_5

# FIG_6